# EUROPEAN PATENT APPLICATION

(11) **EP 4 589 381 A1**
(43) Date of publication of application: **23.07.2025**
(21) Application number: 24153219.1
(22) Date of filing: 22.01.2024
(51) Int. Cl.: G03F 7/00, B23K 26/0622, G21K 1/06

(54) **METHODS, COMPUTER PROGRAMS AND APPARATUSES FOR TREATING AN OPTICAL ELEMENT FOR THE EXTREME ULTRAVIOLET WAVELENGTH RANGE**

(71) Applicant: Carl Zeiss SMS Ltd., 2015600 Misgav (IL)
(72) Inventor: OSHEMKOV, Sergey, 2015600 D.N. Misgav (IL); GUSAROV, Alexander, 2015600 D.N. Misgav (IL); DMITRIEV, Vladimir, 2015600 D.N. Misgav (IL); COHEN, Avi, 2015600 D.N. Misgav (IL); SCHERUEBL, Thomas Franz Karl, 2015600 D.N. Misgav (IL)
(74) Representative: Bardehle Pagenberg Partnerschaft mbB Patentanwälte Rechtsanwälte

(57) **Abstract**

A method for treating an optical element for the extreme ultraviolet (EUV) wavelength range, the method comprises providing a pulsed laser irradiation, wherein the pulsed laser irradiation comprises a plurality of pulse sequences, each pulse sequence comprising a plurality of pulses, wherein a first pulse and a second pulse of the plurality of pulses are separated by a time of 100 ns or less, and directing the laser irradiation onto the optical element for the EUV wavelength range.

## Description

### 1. Technical Field

The present invention relates to methods, computer programs and apparatuses for treating an optical element for the extreme ultraviolet (EUV) wavelength range.

### 2. Background

With ever-decreasing dimensions of feature sizes e.g., on silicon wafers, corresponding lithographic masks, etc., extremely short wavelengths are required to reach the intended level of resolution. For example, EUV lithography (e.g., at a wavelength of 13.5 nm) plays an important role in providing such small features. While the short wavelength allows for an increased resolution, essential for the manufacturing requirements, on the one hand, it also introduces critical complications on the other hand: For example, the reflectance of single metallic surfaces is negligible for these wavelengths, which is why conventional mirrors (e.g., silver (Ag) or gold (Au) mirrors) are not applicable in such applications.

Optical elements, e.g., comprising multilayer systems of alternating Mo/Si layers, however, are suitable as EUV mirrors (e.g., wavelengths of and around 13.5 nm). These multilayer systems typically comprise a periodic alternating arrangement of two materials with a significantly different index of refraction (e.g., molybdenum (Mo) and silicon (Si)). This corresponds to a Bragg mirror, in which constructive interference may be achieved for a certain angle of incidence and a required wavelength range (e.g., in the EUV). Mo/Si multilayers with additional diffusion barriers at selected interfaces have demonstrated a reflectance of 70% or more. The layer thickness required for high near-normal incidence reflectance at 13.5 nm wavelength is in the nanometer range to achieve constructive interference with ca. 50 multilayer periods.

In reality, such multilayer systems are no perfect reflectors. E.g., their interfaces are not chemically abrupt which may result in a diminished optical contrast and consequently to lower reflectance at the respective interface. Imperfections at the (e.g., Mo/Si) interfaces (e.g., resulting from interdiffusion, compound formation, and/or roughness) and unavoidable absorption are the main reasons for said losses.

In general, present methods for treating and/or modifying such optical elements, e.g., comprising multilayer systems, still yield various challenges: For example, some methods rely on illuminating the multilayer systems from the backside (i.e., the side with no absorber material) in order to prevent substantial influence of the absorber pattern load/density on the illumination intensity passing the absorber layer (as observed in frontside illumination). The same treatment of layers closer to pattern, e.g., by frontside illumination, may result in higher reflectivity suppression on the one hand, but on the other hand, it yields disadvantages compared to backside illumination: E.g., backside processing may, e.g., be selected due to its immunity to the pattern load. In detail, an incoming illumination in an area of the multilayer system with a densely packed absorber pattern may be attenuated strongly while in less densely packed areas, it may be attenuated less. Thereby, the effective illumination intensity for multilayer system treatment may vary depending on the position of the multilayer system which may make the process less reproducible, accurate, and/or controllable.

However, in backside illumination, the modification of the optical element requires high intensities and may be accompanied with high intensity-related unwanted side effects: E.g., this process typically suffers from the high induced multilayer system compaction and a relatively bigger registration impact. Further, the high multilayer opacity treatment effects mostly layers close to the back surface.

Therefore, there is still a need to improve methods, computer programs and apparatuses for treating an optical element for the EUV wavelength range, such as to improve reflectivity suppression and/or a compaction.

### 3. Summary

The invention solves the above problems at least in part.

A first aspect of the present invention relates to a method for treating an optical element for the EUV wavelength range. The method comprises providing a pulsed laser irradiation, wherein the pulsed laser irradiation comprises a plurality of pulse sequences, each pulse sequence comprising a plurality of pulses, wherein a first pulse and a second pulse of the plurality of pulses are separated by a time of 100 ns or less, preferably 10 ns or less, more preferably 1 ns or less and directing the laser irradiation onto the optical element for the EUV wavelength range.

The inventors realized that one underlying problem exacerbating modifications of optical elements (for the EUV wavelength range) relates to the following: When processing an optical element using a laser to change the reflectivity in certain areas of the optical element, unwanted displacements of structures on the surface of the optical element may be generated, as the energy input into the energy input into the stack shifts it in the direction of the laser irradiation.

The inventors further found that introducing femtosecond laser pulses as pulse sequences into the optical element, whereby the energy input may be variable over nanoseconds, at least reduces the unwanted displacement of structures (e.g., absorber material) on the optical element. This discovery is based on the understanding of the underlying physical processes following absorption of light (of the laser irradiation) within the optical element: The absorption of laser energy by free electrons occurs at a rate of υₑₑ ≈ 10¹⁴ s⁻¹, which translates to ca. 10 fs. The absorption of laser irradiation raises the electron temperature Tₑ to ca. 10,000 K while, initially, the lattice temperature of the optical element Ti remains at ca. 300 K, when the optical element is at room temperature. Subsequently, the electrons transfer their energy to the lattice with a rate of υₑᵢ ≈ 10¹² s⁻¹, which translates to ca. 1 ps. This is the specific time of metal heating. The absorbed energy then dissipates within the material according to the thermal diffusion coefficient of the material composition of the optical element. As described herein, typical optical elements may, e.g., comprise Mo and Si with diffusion coefficients D_{Mo} = 0.54 cm²/s and D_{Si} = 0.88 cm²/s. The diffusion (described by the equation t ~ L²/D) thus typically occurs on longer timescales than 1 ps for diffusion lengths L of 7 nm or more. The invention accounts for the relevance of the different timescales of the underlying physical processes as described herein:
Especially, the first and second pulse being separated by a time of 100 ns or less proved to allow for improved results in modification of the optical element. Keeping the time between the pulses sufficiently short may allow to induce (thermal) energy of the second pulse into the optical element shortly after the first pulse when the treated optical element has not yet thermally equilibrated (e.g., via thermal diffusion). In detail, experiments with a pulse sequence comprising two pulses could achieve a 50% higher temperature at 200 nm depth within the optical element than in a control experiment with only one pulse (i.e., no pulse sequence) at essentially the same level of damage (e.g., comprising compaction and/or unwanted shifts of absorber elements thereon), and thus the effect reaches more deeply into the treated surface. Further experiments and test simulations shows that even better results can be achieved by providing longer pulse sequences. In detail, longer pulse sequences may comprise three, four, five, or more pulses, e.g. in each pulse sequence.

Generally, a pulse sequence may be understood as a plurality of pulses, wherein the time between two consecutive pulses is less than 100 ns. Vice versa, two pulses that are temporally apart by 100 ns or less may be seen as comprised in the same pulse sequence. Typically, the time between two consecutive pulse sequences is at least three-times longer than the duration of the pulse sequence. In an example wherein the pulse sequences are emitted at a frequency of 100 kHz (which corresponds to a period of 10 µs), the pulses of one pulse sequence may lie within a time window of 100 ns and the time between consecutive pulse sequences may be at least 900 ns. In other examples, however, it is also possible that the pulses of a pulse sequence have a longer separation time, e.g., above 100 ns.

The EUV wavelength range may, e.g., comprise wavelengths between 10 nm and 121 nm, preferably between 10 nm and 20 nm, more preferably between 10 nm and 15 nm.

Herein, a pulse sequence may comprise two or more pulses, each pair of which may be identical or vary in at least one pulse parameter. The at least one pulse parameter may comprise, e.g., a pulse length (e.g., expressed through the full width half maximum of the pulse), an intensity (e.g., expressed through the maximum amplitude of the pulse and/or the total energy of the pulse), a temporal pulse shape (e.g., an essentially Gaussian shape, a triangular shape, etc.), and/or a spatial pulse shape (e.g., a pulse cross section comprising a two-dimensional gaussian distribution or any other regular or unregular shape).

Typically, the pulses of the pulse sequence may be essentially (temporally) equidistant. The pulses of the pulse sequences may be emitted at a certain frequency and/or in a non-periodic (temporal) pattern.

In some examples, the same pulse sequence may be repeated at a certain frequency, e.g., at a frequency of 100 kHz (which corresponds to a period of 10 µs), for a predetermined time.

In one example, the optical element for the EUV wavelength range may comprise a multilayer system and optionally an absorber layer at a frontside of the optical element for the EUV wavelength range. The absorber layer may, e.g., be patterned, preferably comprise a 2D-pattern in the plane of the absorber layer. The multilayer system may, e.g., pose a Bragg mirror and/or be configured to reflect light in the EUV range, preferably between 10 and 20 nm.

For example, the multilayer system may comprise stacked molybdenum (Mo) and silicon (Si) layers. E.g., the Mo-layers may have an average thickness between 2 nm and 4 nm and/or the Si-layers may have an average thickness between 3 nm and 5 nm. The period (in this example between 5 nm and 9 nm) may directly translate to the wavelength maximum of the multilayer system's reflectance. Typical multilayer systems for reflection of 13.5 nm light may comprise ca. 2.9 nm tick Mo-layers and 4.0 nm thick Si-layers.

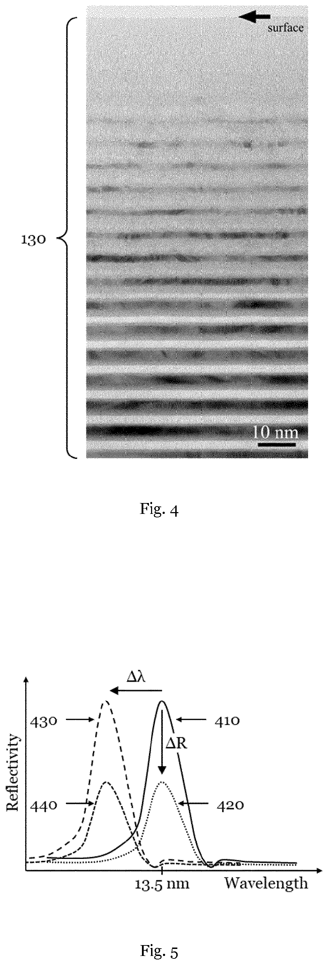

The absorber layer may, e.g., comprise a material that is opaque for EUV light and/or have an average thickness between 10 nm and 200 nm, preferably between 50 nm and 100 nm. In such exemplary optical elements, directing laser irradiation onto the optical element may, e.g., induce Mo-Si diffusion and/or MoₓSi_{y}-formation. These two processes both may result in a blurring of the layers of the multilayer system (as shown, e.g., in Fig. 4) and thus induce a change (e.g., a reduction) of reflectivity.

The absorber layer may, e.g., in the example of the optical element being a photolithography mask, be decisive for the pattern imprinted from the mask onto another structure. Thus, it is highly important to not adversely affect the absorber pattern in the method described herein. When compaction occurs, absorber pattern elements may shift due to the induced strain thereon which damages the optical element. The nominal size of the structural elements generated by the absorber pattern in a photoresist may be called critical dimension (CD). This size and its variation (CDU Critical Dimension Uniformity) are central parameters for the quality of a photolithography mask. Thus, the method described herein may significantly improve critical dimension control by avoiding compaction effects which in turn has a positive effect on CD.

The pattern on the mask may be transferred onto the wafer via a lithography system. As such lithography system typically may work in the EUV range, these may be purely catoptric/reflective systems. On the wafer, a photosensitive resist may be exposed to the image of the mask determined by the absorber pattern. The region on the mask containing the patterns is typically surrounded by a border region, the so-called a black border which may have a reflectance as low as possible such that said black borders reflect only very little (EUV) radiation. Problems arise when said black border are not perfectly black. At the same time, however, the black borders must be generated carefully, i.e., without damaging the absorber layer. The method described herein may - when used for black border generation - achieve just that.

In one example, a wavelength of the pulsed laser irradiation may be between 400 and 1500 nm, preferably between 700 nm and 1100 nm.

Working in this wavelength range is advantageous in various aspects: On the one hand, many substrates (e.g., comprising quartz) and/or coatings (e.g., comprising tantalum boride TaB) that may be used for optical elements as described herein are typically sufficiently transparent for the indicated wavelength ranges. This allows for treatment of the parts of the optical element in transmission through such substrates and/or coatings. On the other hand, there are various laser sources that may provide high-quality laser irradiation in this wavelength range and may be available at low costs. In one example, a titanium-sapphire laser (i.e., Ti:Al₂O₃ lasers) being a tunable laser emitting red and near-infrared laser irradiation in the range from ca. 650 nm to 1100 nm, may be used for the methods and apparatuses described herein.

For example, the repetition rate of the pulsed laser irradiation may be between 1 kHz and 1 MHz, preferably between 50 kHz and 200 kHz. A laser pulse length of the pulsed laser irradiation may be in the femtosecond range, preferably between 10 fs and 1000 fs, more preferably between 80 fs and 300 fs. The pulse sequence may, e.g., be repeated at a repetition frequency as described herein.

As absorption of laser energy by free electrons occurs at a rate of υₑₑ ≈ 10¹⁴ s⁻¹, which translates to ca. 10 fs, it is particularly advantageous to use femtosecond laser pulses as these allow for localized heating.

These pulse parameters may, e.g., be achieved by laser sources comprising mode-locked oscillators. These may generate ultrashort pulses with the above pulse length. The repetition rate may, e.g., be determined by the round-trip optical path of the laser source, e.g., a titanium-sapphire laser as described herein. Thereby, such laser irradiation may be provided in a relatively cheap and reliable way one the one hand. On the other hand, the inventors found that providing short pulses as described herein allows to reduce unwanted side effects that are commonly observed in control experiments with longer laser pulses (e.g., in the nanosecond range). Providing both, sufficiently short pulses and sufficiently high repetition rates allow to avoid such side effects while keeping the working times sufficiently short.

In some examples, the first pulse and the second pulse of the plurality of pulses may be separated by a time of at least 10 ns.

The inventors found that typical optical elements, e.g., comprising Mo-Si multilayer systems as described herein, have high absorption coefficients. Thus, laser irradiation used to modify the optical element is typically absorbed mostly at and near the irradiated surface of the irradiated optical element. Thus, deeper depths may not be predominantly treated directly be the laser irradiation but rather by thermal diffusion driven processes. However, deep depths may not always be reached. Especially when femtosecond laser pulses are utilized. In order to exploit the advantages of reduced side effects associated with such femtosecond laser pulses on the one hand but also treating deep depths of the optical element on the other hand, the inventors identified the importance of tailoring the sequence duration. E.g., for equidistant pulses (separated by a time interval Δt), the duration of a pulse sequence comprising n pulses, the duration of the pulse sequence may amount to (n-1)·Δt.

In detail, providing pulse sequences that are sufficiently long (e.g., 10 ns or more) could increase the temperature in deep depths of the optical element (e.g., at 200 nm depth) relative to the temperature reached at the irradiated surface of the optical element by more than an order of magnitude.

In some examples, the pulses of the plurality of pulses may be repeated at a frequency of 10 MHz to 1 GHz.

Such high (intra-sequence) repetition rate was shown to yield various advantages. On the one hand, such sequences may be provided with high accuracy and reliability. On the other hand, the high repetition rate (and thus the short times between consecutive pulses) is high enough (or short enough, respectively) to be on the same timescale as the underlying physical processes (e.g., heat diffusion within the optical element on the relevant length scales). Thus, one may optimize the efficiency of the treatment and/or modification of the optical element associated with said underlying physical processes.

Such pulse sequences may, e.g., be provided by a laser source comprising a so-called burst mode laser. The laser source may, e.g., comprise a Q-switched laser and/or a continuously operating mode-locked laser (e.g., as described herein). Such laser sources may, e.g., further comprise a pulse picker, an optical modulator with a continuously variable transmissivity, and/or an optical amplifier. In detail, for providing short pulses with a high repetition rate, the laser source (e.g., comprising a mode-locked laser) may further comprise a pulse splitter, which may be configured to convert a pulse emitted by the laser source into a sequence of pulses (e.g., 2, 4 or 8 pulses).

In some examples, at least one of the pulses may comprise at least one sub-sequence comprising a plurality of sub-pulses. For example, a first sub-pulse and a second sub-pulse of the plurality of sub-pulses may be separated by a time between 1 ps and 100 ns, preferably between 10 ps and 10 ns, more preferably between 100 ps and 1 ns.

By providing a sequence of pulses, wherein at least one of the pulses comprises another sub-sequence of pulses, the advantageous effects described herein may be further improved. In detail, the optical element may be treated even more efficiently while keeping the total energy deposited into the material (and potentially leading to negative side effects like compaction) low.

In some examples, the sub-pulses of the plurality of sub-pulses may be repeated at a frequency of 1 GHz to 100 GHz, preferably of 1 GHz to 10 GHz.

Such embodiments yield the advantages described herein with reference to the pulse sequences.

In some examples, the first pulse may comprise an intensity that is different from an intensity of the second pulse. The same may analogously apply to a first sub-pulse and a second sub-pulse of the sub-sequence.

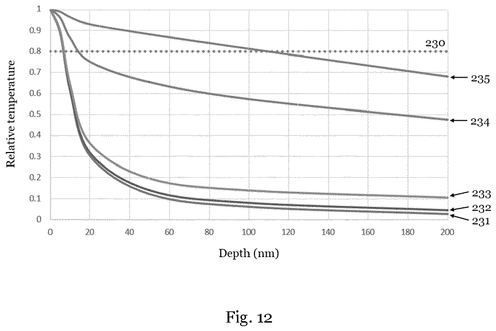

The inventors found that thereby, the heat distribution induced within the optical element may be beneficially tailored as described herein, e.g., in reference to Fig. 12 and Table 3.

The intensity may, e.g., be defined by the energy per (sub-)pulse. For a pulse comprising a sub-sequence, the pulse intensity may correspond to the cumulative sub-pulse energies of the sub-sequence.

In detail, the sequence and/or sub-sequence may comprise a sequence envelope and/or a sub-sequence envelope. Such envelope may comprise a monotonic decrease or increase in pulse intensity within at least a part of the sequence and/or sub-sequence, respectively. In test measurements and simulations, especially monotonically decreasing envelopes were shown to achieve the desired heating of deep layers of the optical element and may be seen as particularly advantageous.

In some examples, the laser irradiation is directed onto a surface of the optical element for the EUV wavelength range with a diameter in the range between 1 µm to 100 µm.

A spot size of 1 µm to 100 µm allows to quickly treat relatively large areas of the optical element. Further, it is large compared to typical thicknesses of optical elements and/or the relevant heat diffusion lengths. This justifies the 1D modelling of heat propagation described herein, which forms part of the inventors understanding of the underlying processes essential for arriving at the invention described herein.

In some examples, the method may further comprise directing the laser irradiation onto a first region of the optical element for a first time period and directing the laser irradiation onto a second region of the optical element for the EUV wavelength range for a second time period.

Thereby, the optical element may be treated in a stepwise process. Typically, irradiating the first, second, and optionally third, fourth, and further regions may be performed in a scanning fashion, e.g., in a predetermined scanning pattern. This process may, e.g., controlled by computing means, e.g., in an automized fashion. Thereby, the amount of work required may be significantly reduced and/or the accuracy and reliability of the method may be increased.

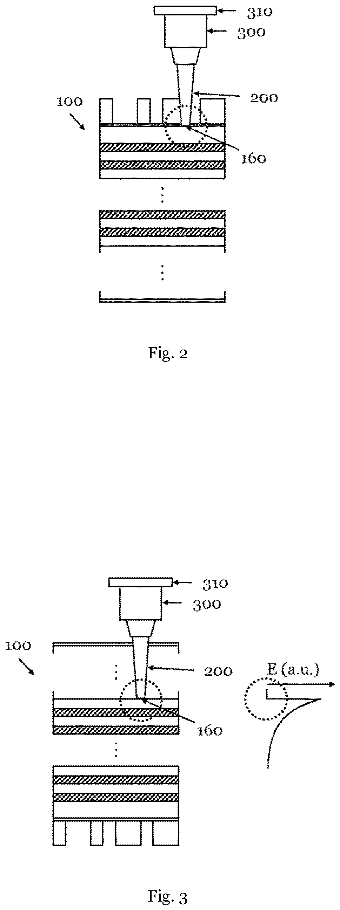

For example, directing the laser irradiation onto a region of the optical element may comprise directing the laser irradiation onto a backside of the optical element (cf. Fig. 3).

In backside processing, advantageously the laser irradiation does not pass the absorber layer as described herein, which may have different pattern densities on the order of magnitude of typical laser irradiation spot sized as described herein. Thus, backside processing may be performed at high accuracy and reliability and does not require for, e.g., any pattern density-dependent correction of the laser power.

In another example, directing the laser irradiation onto a region of the optical element may comprise directing the laser irradiation onto a frontside of the optical element (cf. Fig. 2).

In frontside processing, advantageously the pulse energy is predominantly absorbed by the frontside layers of the optical element, which are typically those layers that are desired to be modified/treated in the method described herein.

The method may, for example, further comprise reducing the reflectivity of the multilayer system of light in the EUV range by 0% to 10%, preferably by 2% to 8% and/or shifting the wavelength of maximum reflectivity by 0 nm or more and/or 1 nm or less, preferably by 0.1 nm or more and/or 0.5 nm or less.

These values proved to be sufficient to achieve the goals of the method described herein, on the one hand, and not harming the optical element, e.g., the absorber element(s)/pattern, on the other hand.

In another example, the method may, for example, further comprise reducing the reflectivity of the optical element of light in the EUV range by at least 40% and/or shifting the wavelength of maximum reflectivity by at least 1 nm.

The reduction in reflectivity R_{%} may, e.g., be defined as the ratio between the reflectivity at 13.5 nm of the multilayer system before and after treating it by the method described herein: R_{%} = R_{after/}R_{before}. Typically, the reflection spectrum of a reflective optical element for the EUV wavelength range has a reflectance maximum at a certain wavelength for a certain angle of incidence. The wavelength of maximum reflectivity may, e.g., determined by fitting a peak function (e.g., a Gauss peak) to said spectrum and/or by simply extracting the wavelength position of the highest value of the spectrum. Typically, the wavelength of maximum reflectivity before treating the optical element according to the method described herein may be at or around 13.5 nm (e.g., between 12 nm and 14 nm). Typical angles of incidence may, e.g., be in the range of 0° to 45° relative to the surface normal of the optical element.

The method described herein may, for example, further comprise adjusting at least one parameter of the pulsed laser irradiation based at least in part on the dimensions and/or the material properties of the optical element for the EUV wavelength range.

For example, one may consider the timescales associated with thermal diffusion within the optical element. Table 1 lists some exemplary lengths for thermal diffusion in Mo-Si multilayer systems associated with timescales between 10 ps and 10 µs. Based thereon, it becomes apparent that longer (e.g., ns) pulses allows to get a more homogeneous heating of the optical element due to heat propagation in optical element. It may therefore be beneficial to increase the effective pulse width in order to heat deep lasers of the optical element to be treated. This may particularly be relevant for backside irradiation as described herein to reduce registration for back side processing. However, simply increasing the pulse length to nanosecond pulses may not be sufficient as it also may come along with the disadvantageous side effects described herein like compaction.

**Table 1**

| t | L (nm) |
|---|---|
| 10 ps | 30 |
| 0.4 ns | 188 |
| 1 ns | 297 |
| 10 µs | 29665 |

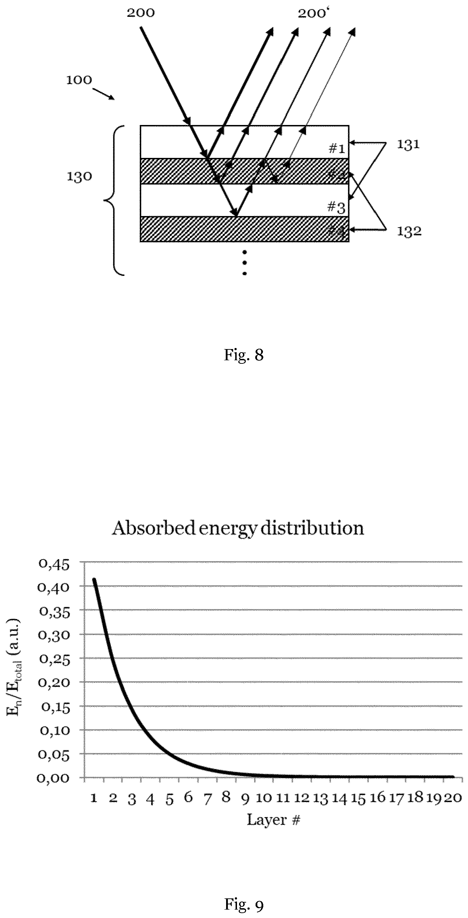

As described herein, the at least one pulse parameter may comprise, e.g., a pulse length, the intensity, a temporal pulse shape, a sequence envelope, a sub-sequence envelope, and/or a spatial pulse shape. In detail, it may be particularly advantageous to adjust the parameter of the pulsed laser irradiation to the depth at which one wants to modify the optical element. Some aspects that may considered are described in reference to Figs. 8 and 9.

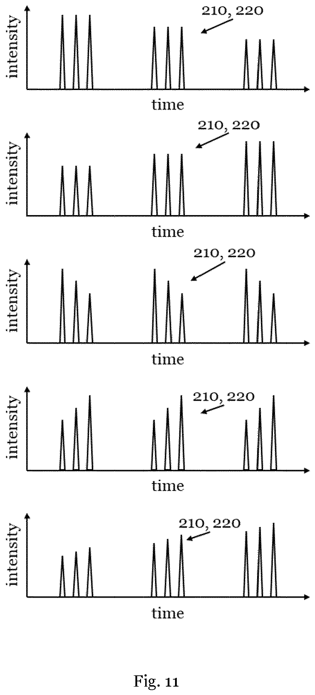

Generally, the at least one parameter of the pulsed laser irradiation may be chosen such as to control the depth-dependent thermal distribution within the optical element. E.g., the method described herein may induce a certain temperature at a depth (of, e.g., 50 nm, 100 nm, 150 nm, 200 nm or more) within the optical element that amounts to at least 25%, 50% or 75% of the induced surface temperature at the surface of the optical element the laser irradiation is directed onto. Some examples how to achieve this are described herein in reference to Fig. 11. The depth may, e.g., be measured in an orthogonal direction relative to the surface and/or from the irradiated region of the surface of the optical element and/or of the multilayer system comprised therein.

A second aspect of the invention relates to a computer program comprising instructions for carrying out the steps of the method described herein.

Providing a computer program, e.g., for (at least partly) automatically operating an apparatus as described herein, may increase the accuracy, reliability and treatment speed of the method described herein. Further, it may significantly reduce the amount of labor for treating optical elements.

A third aspect of the invention relates to an apparatus for treating an optical element for the EUV wavelength range, wherein the apparatus comprises a laser source configured to provide a pulsed laser irradiation, wherein the pulsed laser irradiation comprises a plurality of pulse sequences, each pulse sequence comprising a plurality of pulses, wherein a first pulse and a second pulse of the plurality of pulses are separated by a time of 100 ns or less, and means for directing the laser irradiation onto the optical element for the EUV wavelength range.

In some examples, the apparatus may further comprise a control means configured to control the apparatus to, preferably automatically, execute the steps of the method described herein. E.g., the control means may control the laser irradiation by controlling the used laser source. This may, e.g., comprise controlling at least one laser parameter (e.g., by varying it or keeping it constant) and/or controlling the region onto which the laser irradiation is directed (e.g., comprising an automated scanning).

In general, any steps of the method described herein may be implemented as instructions of the computer program and/or as means of the apparatus described herein, and vice versa.

### 4. Description of the figures

Fig. 1 shows an exemplary EUV photolithography mask comprising a multilayer system.
Fig. 2 shows the exemplary EUV photolithography mask of Fig. 1 processed by frontside laser irradiation.
Fig. 3 shows the exemplary EUV photolithography mask of Fig. 1 processed by backside laser irradiation.
Fig. 4 shows a high-resolution transmission electron micrograph of an exemplary multilayer system irradiated with femtosecond laser pulses at a fluence of 280 mJ/cm².
Fig. 5 shows four exemplary reflectance spectra of treated and untreated multilayer systems.
Fig. 6 shows a microscopy image top view of a laser irradiation-treated exemplary multilayer system.
Fig. 7 shows an exemplary depth profile of a laser irradiation-treated exemplary multilayer system acquired by atomic force microscopy and one representative cut through the depth profile.
Fig. 8 shows a schematic representation of light reflection and absorption at different layers of an exemplary multilayer system.
Fig. 9 shows a schematic representation of the absorbed energy distribution in an exemplary multilayer system linked to the physical processes illustrated in Fig. 8.
Fig. 10 shows an exemplary laser irradiation intensity over time, wherein the laser irradiation comprises a sequence comprising a sub-sequence of sub-pulses.
Fig. 11 schematically shows five exemplary ways of controlling a sequence envelope.
Fig. 12 shows an exemplary relative temperature distribution as a function of depth into the multilayer system created upon different temporal pulse sequences.

### 5. Detailed description of preferred embodiments

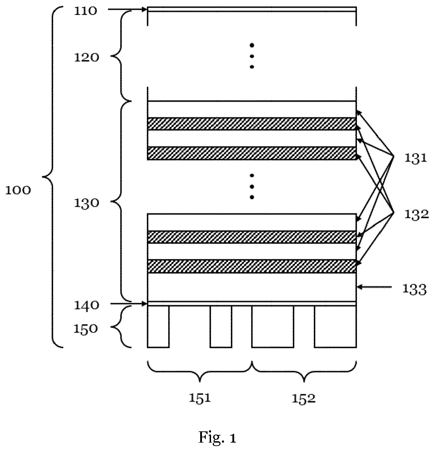

Fig. 1 shows an EUV photolithography mask 100 comprising a multilayer system 130 as one example for an optical element 100 as described herein. The optical element may comprise a layered architecture 100. In the example of Fig. 1, the layers may extend in the horizontal plane. The layers may typically have lateral dimensions in the horizontal plane that extend the thickness in the vertical direction (i.e., the stacking direction of the layers) by many orders of magnitude.

The exemplary optical element 100 comprises a backside coating 110 applied onto a substrate 120. The backside coating may, e.g., comprise TaB and/or have a thickness between 10 nm and 500 nm, preferably between 50 nm and 100 nm. The substrate may, e.g., comprise a low thermal expansion material and/or have a thickness in the mm range, preferably between 1 mm and 10 mm, more preferably between 6 mm and 7 mm. The three dots illustrate that the drawing of Fig. 1 is not scaled but the substrate may be much thicker than shown here.

The optical element 100 may further comprises a multilayer system 130 comprising two alternatingly stacked layers, a first layer 131 and a second layer 132. For example, the first layer 131 and the second layer 132 may comprise materials with different refractive indices. This allows them to form a reflective Bragg mirror, e.g., as described herein. The first layer 131 may, e.g., comprise Si and/or have a thickness of ca. 4.0 nm as shown in the example of Fig. 1. The second layer 132 may, e.g., comprise Mo and/or have a thickness of ca. 2.9 nm as shown in the example of Fig. 1. Again, the three dots illustrate that the drawing of Fig. 1 is not scaled but the multilayer structure 130 may be much thicker than shown here. Typically, multilayer systems 130 may comprise between 10 and 200 bilayers (e.g., each comprising one first layer 131 and one second layer 132), e.g., resulting in thicknesses of the multilayer system 130 in the nanometer range. The multilayer system may be terminated by a final layer 133. In the example of Fig. 1, the final layer 133 may comprise Si and/or have a thickness that is different from the first and/or second layer 131, 132 and/or may be between 3 nm and 11 nm. Other exemplary optical elements may, e.g., comprise three or more alternating layers.

The optical element 100 may, e.g., further comprise a cap layer 140. The cap layer 140 may, e.g., comprise ruthenium (Ru). The multilayer system 130 may thus be sandwiched between the substrate 120 and the cap layer 140. The cap layer 140 may be attached to the multilayer system 130 on the one side and to an absorber layer 150 on the other side.

The absorber layer 150 may be patterned such as to allow it to be used in a photolithography mask. It may comprise relatively densely-packed areas 152 (e.g., areas with 50% surface coverage or more) and less densely-packed areas 151 (e.g., areas with less than 50% surface coverage).

Fig. 2 shows the exemplary optical element 100 of Fig. 1 processed by frontside laser irradiation. Fig. 3 shows the exemplary optical element 100 of Fig. 1 processed by backside laser irradiation. In both cases, a laser source 300 providing the laser irradiation 200 is provided and directs the laser irradiation onto a region 160 of the optical element 100. The energy is absorbed mostly right at the region 160 of the multilayer system that is irradiated by the laser irradiation 200. This is illustrated schematically by the graph on the right of Fig. 3 showing how the deposited energy decreases with increasing depth into the optical element 100. This applies analogously for the scenario of Fig. 2 (frontside irradiation) and 3 (backside irradiation).

The laser source may, e.g., as shown in Figs. 2 and 3, be mounted to a means for moving the laser source 310. The means for moving the laser source 310 may, e.g., comprise a two- and/or three-dimensional stage allowing the laser source to be moved relative to the optical element 100, e.g., in an automized way. This may, e.g., be controlled by an according computer program as described herein.

Fig. 4 shows a high-resolution transmission electron micrograph of an exemplary multilayer system 130 irradiated with femtosecond laser pulses at a fluence of 280 mJ/cm². The surface (at the top of Fig. 4) is treated by the laser irradiation (not shown). This treatment resulted in the diminishing of the layers of the multilayer system 130 near the surface while at the bottom, the individual layers are clearly visible as less energy was deposited there.

Fig. 5 shows four exemplary reflectance spectra of treated 420, 430, 440 and untreated optical elements 410.

The first reflectance spectrum 410 corresponds to an untreated optical element. The reflectance spectrum 410 comprises a high amplitude and is centered at around 13.5 nm.

The second reflectance spectrum 420 corresponds to a first treated optical element. The reflectance spectrum 420 comprises a reduced amplitude and is (like the reflectance spectrum 410 of the untreated optical element) centered at around 13.5 nm. This may, e.g., be achieved by the depletion of the layers of a multilayer system as, e.g., shown in Fig. 4. The reflectance spectrum 410 of the untreated optical element and the reflectance spectrum 420 of the first treated optical element thus essentially differ by an amplitude difference ΔR.

The third reflectance spectrum 430 corresponds to a second treated optical element. The reflectance spectrum 430 comprises essentially the same amplitude (like the reflectance spectrum 410 of the untreated optical element) and is centered at around a wavelength shorter than 13.5 nm. This may, e.g., be achieved by compaction of the layers of the layers of a multilayer system. The reflectance spectrum 410 of the untreated optical element and the reflectance spectrum 430 of the second treated optical element thus essentially differ by a wavelength shift Δλ.

The fourth reflectance spectrum 440 corresponds to a third treated optical element. The reflectance spectrum 440 comprises a reduced amplitude (e.g., achieved by the depletion of the layers) Further, it is centered at around a wavelength shorter than 13.5 nm. (e.g., achieved by compaction of the layers). The reflectance spectrum 410 of the untreated optical element and the reflectance spectrum 440 of the third treated optical element thus essentially differ by an amplitude difference ΔR and a wavelength shift Δλ.

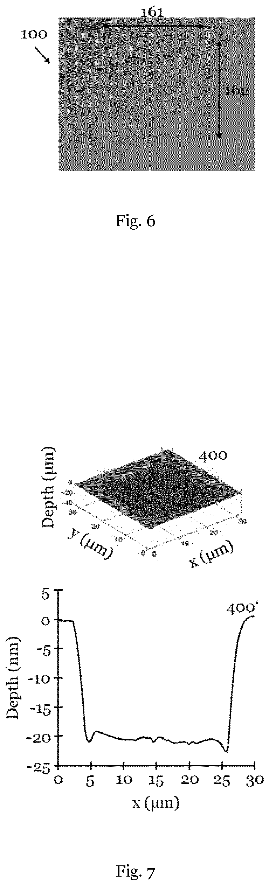

Fig. 6 shows a microscopy image top view of a laser irradiation-treated optical element 100 comprising a multilayer system acquired by optical microscopy. The treated area may be perceived as a square-shaped area with border lengths 161, 162 of ca. 20 µm each.

Fig. 7 shows an exemplary atomic force microscopy depth profile 400 of a laser irradiation-treated optical element 100 comprising a multilayer system acquired by atomic force microscopy and one representative cut 400' through the depth profile. The cut 400' illustrates the effect of compaction: the depth of the optical element within the treated area differs by ca. 20 nm from the untreated area.

Fig. 8 shows a schematic representation of light reflection and absorption at different layers of an exemplary multilayer system 130 of an optical element 100. An exemplary Mo-Si multilayer system 130 of the optical element 100 may be characterized as shown in Table 2.

**Table 2**

| | h (nm) | n | k | z (µm) | ρ (g/cm³) | C (J/gK) | Tₘ (°C) |
|---|---|---|---|---|---|---|---|
| Mo | 2.9 | 3.6371 | 3.365 | 0.0189 | 10.2 | 0.251 | 2623 |
| Si | 4.0 | 3.681 | 0.005 | 12.7324 | 2.329 | 0.7 | 1412 |
| Qz | | 1.4534 | 0 | | | | |

Table 2 relates to the thickness h, the index of refraction n (for 800 nm irradiation), the extinction coefficient k (for 800 nm irradiation), the penetration depth, at which light intensity drops e-times z, the density ρ, the heat capacity C, and the melting temperature Tₘ of the respective material. At 800 nm, Mo 132 absorbed light much more efficiently than Si 131. Following the equation for extinction (~exp(-kz/λ)), the Mo layer practically absorb almost all the energy. The reflectivity at the Mo-Si interface at 800 nm is ca. 0.174.

In result, the intensity of light decreases the deeper the incoming laser irradiation 200 penetrates the optical element 130. The reflected light 200' thus is also weaker, the deeper the interface it is reflected by. The underlying reason for this depth-dependence of the light intensity is the absorption by the Mo- 132 and Si-layers 131.

Fig. 9 shows a schematic representation of the absorbed energy distribution in an exemplary multilayer system linked to the physical processes illustrated in Fig. 8.

While the first Mo-layer absorbs ca. 40% of the incoming energy, this ration drops to less than 25% for the second Mo-layer, less than 15% for the third Mo-layer and so on. The absorption by the Si-layers may be neglected in this model (cf. Table 2).

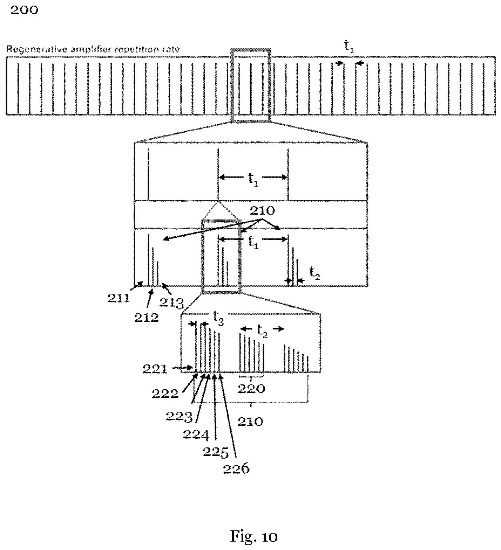

Fig. 10 shows an exemplary laser irradiation intensity over time, wherein the laser irradiation 200 comprises a sequence 210 comprising pulses 211, 212, 213. The time t₁ is the time between two consecutive (pulse) sequences 210 and the time t₂ is the time between two consecutive pulses 211, 212, 213. Optionally, each (or at least one) of the pulses 211, 212, 213 may comprise a sub-sequence 220 comprising a plurality of sub-pulses 221, 222, 223, 224, 225, 226. Time t₃ is the time between two consecutive sub-sequences 220.

In the example of Fig. 10, the envelope of the sequence 210 as well as of the optional sub-sequences is controlled to monotonically decrease the intensity of the pulses within each sequence 210 and within each sub-sequence 220.

Fig. 11 schematically shows five exemplary ways of controlling the sequence envelope. The shown concept may analogously apply to an envelope control of a sequence 210 and/or a sub-sequence 220 as described herein.

The first panel shows that the intensity for all pulses is constant within a (sub-) sequence 210, 220 but decreases monotonically for the next (sub-)sequence(s) 210, 220.

The second panel shows that the intensity for all pulses is constant within a (sub-) sequence 210, 220 but increases monotonically for the next (sub-)sequence(s) 210, 220.

The third panel shows that the intensity decreases monotonically within a (sub-) sequence 210, 220 wherein subsequent (sub-)sequences 210, 220 have the same envelope.

The fourth panel shows that the intensity increases monotonically within a (sub-) sequence 210, 220 wherein subsequent (sub-)sequences 210, 220 have the same envelope.

The fifth panel shows that the intensity increases monotonically within a (sub-) sequence 210, 220 and increases monotonically across subsequent (sub-)sequences 210, 220 for a predetermined number of subsequent (sub-)sequences 210, 220 (in this example three).

Fig. 12 shows exemplary relative temperature distributions 231, 232, 233, 234, 235 as a function of depth into the multilayer system created upon different temporal pulse sequences 210 and/or sub-sequences 220. Further, Fig. 12 shows a reference threshold 230 of 80% of the temperature at the irradiated surface of the treated optical element.

The first exemplary relative temperature distributions 231 may, e.g., be induced by single pulse irradiation (i.e., laser irradiation comprising no pulse sequence). It can be seen that all further irradiations result in improved relative temperature distributions 232, 233, 234, 235.

The second exemplary relative temperature distributions 232 may, e.g., be induced by a laser irradiation comprising a pulse sequence comprising two pulses separated by a time of 25 ns.

The third exemplary relative temperature distributions 233 may, e.g., be induced by a laser irradiation comprising a pulse sequence comprising ten pulses, wherein consecutive pulses are separated by a time of 25 ns.

The fourth exemplary relative temperature distributions 234 may, e.g., be induced by a laser irradiation comprising a pulse sequence comprising ten pulses, wherein consecutive pulses are separated by a time of 16 ns. Further, each pulse comprises a sub-sequence of ten sub-pulses, wherein consecutive sub-pulses are separated by a time of 0.4 ns.

The fifth exemplary relative temperature distributions 235 may, e.g., be induced by a laser irradiation comprising a pulse sequence comprising ten pulses, wherein consecutive pulses are separated by a time of 16 ns. Further, each pulse comprises a sub-sequence of ten sub-pulses, wherein consecutive sub-pulses are separated by a time of 0.4 ns. Additionally (and in contrast to the fourth exemplary relative temperature distribution 234), the intensity of the sub-pulses fades by 10% (of the intensity of the first sub-pulse of the sub-sequence) between consecutive pulses within the sub-sequence (i.e., a monotonically decreasing intensity throughout the sub-sequence).

Interestingly, one can see that the different aspects of the invention like adjusting the sequence duration, the time between pulses, and/or the envelope control may substantially improve the result achieved by the methods allowing to reach a more evenly distributed temperature throughout the treated optical element. The results are summarized in Table 3.

One can see that gradually the temperature distribution increases from example #1 to example #5 from Fig. 12. This may be quantified, e.g., by means of the ration between the temperature at 200 depth and the temperature at the surface, i.e., 0 nm depth (T_{200 nm} / T_{0 nm}) or the depth at which the temperature drops to 80% of the temperature at the surface d_{80%}. Both measures are significantly increasing with the measures taken by examples #2 - #5 compared to the reference example #1.

**Table 3**

| Example | n₁ | t₁ (ns) | n₂ | t₁ (ns) | Envelope | T_{200 nm} / T_{0 nm} | d_{80%} (nm) |
|---|---|---|---|---|---|---|---|
| #1 (231) | 1 | - | - | - | - | 2.6% | 5 |
| #2 (232) | 2 | 25 | - | - | - | 4.3% | 6 |
| #3 (233) | 10 | 25 | - | - | - | 11 % | 8 |
| #4 (234) | 10 | 16 | 10 | 0.4 | - | 47% | 13 |
| #5 (235) | 10 | 16 | 10 | 0.4 | yes | 68% | 108 |

## Claims

1. A method for treating an optical element for the extreme ultraviolet (EUV) wavelength range, the method comprising:
providing a pulsed laser irradiation, wherein the pulsed laser irradiation comprises:
a plurality of pulse sequences, each pulse sequence comprising a plurality of pulses; wherein a first pulse and a second pulse of the plurality of pulses are separated by a time of 100 ns or less; and
directing the laser irradiation onto the optical element for the EUV wavelength range.

2. The method of claim 1, wherein
a wavelength of the pulsed laser irradiation is between 400 and 1500 nm, preferably between 700 nm and 1100 nm;
the repetition rate of the pulsed laser irradiation is between 1 kHz and 1 MHz, preferably between 50 kHz and 200 kHz; and/or
a laser pulse length of the pulsed laser irradiation is in the femtosecond range, preferably between 10 fs and 1000 fs, more preferably between 80 fs and 300 fs.

3. The method of claim 1 or 2, wherein the first pulse and the second pulse of the plurality of pulses are separated by a time of at least 10 ns.

4. The method of any of claims 1-3, wherein the pulses of the plurality of pulses are repeated at a frequency of 10 MHz to 1 GHz.

5. The method of any of claims 1-4, wherein at least one of the pulses comprises at least one sub-sequence comprising a plurality of sub-pulses; wherein a first sub-pulse and a second sub-pulse of the plurality of sub-pulses are separated by a time between 1 ps and 100 ns.

6. The method of claim 5, wherein the sub-pulses of the plurality of sub-pulses are repeated at a frequency of 1 GHz to 100 GHz, preferably of 1 GHz to 10 GHz.

7. The method of any of claims 1-6, wherein the first pulse comprises an intensity that is different from an intensity of the second pulse.

8. The method of any of claims 1-7, wherein the laser irradiation is directed onto a surface of the optical element for the EUV wavelength range with a diameter in the range between 1 µm to 100 µm.

9. The method of any of claims 1-8, wherein the optical element for the EUV wavelength range comprises a multilayer system and optionally an absorber layer at a frontside of the optical element for the EUV wavelength range; wherein
the multilayer system is preferably configured to reflect light in the in the EUV range, preferably between 10 and 20 nm.

10. The method of any of claims 1-9, wherein the directing the laser irradiation onto the optical element for the EUV wavelength range comprises:
directing the laser irradiation onto a first region of the optical element for the EUV wavelength range for a first time period; and
directing the laser irradiation onto a second region of the optical element for the EUV wavelength range for a second time period.

11. The method of any of claims 1-10, wherein the directing the laser irradiation onto the optical element for the EUV wavelength range comprises directing the laser irradiation onto a backside of the optical element for the EUV wavelength range.

12. The method of any of claims 9-11, further comprising:
reducing the reflectivity of the multilayer system of light in the EUV range by 0% to 10%, preferably by 2% to 8%; and/or
shifting the wavelength of maximum reflectivity by 0 nm to 1 nm, preferably by 0.1 nm to 0.5 nm.

13. The method of any of claims 1-12, further comprising adjusting at least one parameter of the pulsed laser irradiation based at least in part on the dimensions of the optical element for the EUV wavelength range.

14. An apparatus for treating an optical element for the extreme ultraviolet (EUV) wavelength range, wherein the apparatus comprises:
a laser source configured to provide a pulsed laser irradiation, wherein the pulsed laser irradiation comprises:
a plurality of pulse sequences, each pulse sequence comprising a plurality of pulses; wherein a first pulse and a second pulse of the plurality of pulses are separated by a time of 100 ns or less; and
means for directing the laser irradiation onto the optical element for the EUV wavelength range.

15. The apparatus of claim 14, further comprising a control means configured to control the apparatus to, preferably automatically, execute the steps of the method of any of claims 1-13.
